(19) Europäisches Patentamt / European Patent Office / Office européen des brevets

(11) **EP 4 564 040 B1**

(12) **EUROPEAN PATENT SPECIFICATION**

(45) Date of publication and mention
of the grant of the patent:
**20.05.2026 Bulletin 2026/21**

(21) Application number: **24215714.7**

(22) Date of filing: **27.11.2024**

(51) International Patent Classification (IPC):
*G01R 31/64* *(2020.01)*

(52) Cooperative Patent Classification (CPC):
**G01R 31/64**

(54) **ULTRACAPACITOR MODULE WITH SELF-TESTING**

ULTRAKONDENSATORMODUL MIT SELBSTTEST

MODULE ULTRACONDENSATEUR AVEC AUTO-TEST

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: 28.11.2023 US 202363603254 P
16.01.2024 US 202463621179 P
07.11.2024 US 202418939979

(43) Date of publication of application:
**04.06.2025 Bulletin 2025/23**

(73) Proprietor: **Aptiv Technologies AG
8200 Schaffhausen (CH)**

(72) Inventors:
• **DEUTSCH, Robert**
**8200 Schaffhausen (CH)**
• **WANG, Xu**
**8200 Schaffhausen (CH)**
• **LU, Dongliang**
**8200 Schaffhausen (CH)**

(74) Representative: **Bardehle Pagenberg
Partnerschaft mbB
Patentanwälte Rechtsanwälte
Prinzregentenplatz 7
81675 München (DE)**

(56) References cited:
**US-A1- 2018 166 892**

• **LAADJAL KHALED ET AL: "Supercapacitors
Online Parameters Estimation and State-of-
Health Determination in Hybrid", 2021 IEEE 13TH
INTERNATIONAL SYMPOSIUM ON
DIAGNOSTICS FOR ELECTRICAL MACHINES,
POWER ELECTRONICS AND DRIVES
(SDEMPED), IEEE, vol. 1, 22 August 2021
(2021-08-22), pages 261 - 266, XP034026749, DOI:
10.1109/SDEMPED51010.2021.9605527**
• **RUBARTSCH MARVIN ET AL: "On-Line
Diagnosis of Supply Voltage Stabilizing
Capacitors in Automotive Electronic Systems",
2023 IEEE VEHICLE POWER AND PROPULSION
CONFERENCE (VPPC), IEEE, 24 October 2023
(2023-10-24), pages 1 - 6, XP034532389, DOI:
10.1109/VPPC60535.2023.10403181**
• **QUINTANS CAMILO ET AL: "Methodology to
Obtain the Voltage-Dependent Parameters of a
Fourth-Order Supercapacitor Model With the
Transient Response to Current Pulses", IEEE
TRANSACTIONS ON POWER ELECTRONICS,
INSTITUTE OF ELECTRICAL AND
ELECTRONICS ENGINEERS, USA, vol. 32, no. 5,
1 May 2017 (2017-05-01), pages 3868 - 3878,
XP011640395, ISSN: 0885-8993, [retrieved on
20170202], DOI: 10.1109/TPEL.2016.2593102**

**Description**

**TECHNICAL FIELD**

This disclosure is directed to an ultracapacitor module (UCM) with autonomous self-learning/monitoring of parameters associated with the UCM.

**BACKGROUND**

The health/effectiveness of battery packs are typically assessed using parameters such as State of Health (SOH), State of Charge (SOC), and State of Function (SOF). For battery packs utilizing ultracapacitors, additional parameters utilized to assess health of the ultracapacitor cells includes Equivalent Series Resistance (ESR) and Capacitance. To measure ESR and capacitance requires a precision current source in combination with voltage measurements.

Typically, an ultracapacitor module connected to a voltage supply bus has no ability to control the current sourced from or provided to the ultracapacitor module. An example of this may be found in an ultracapacitor module in a voltage stabilization system that increases the voltage available on the voltage supply bus while a starter system of an internal combustion engine is engaged and includes a parallel DC/DC converter to recharge the capacitors in the ultracapacitor module. Another example is a backup power supply module which increases the voltage of the voltage supply bus of a vehicle when the bus voltage sags. This module also includes a parallel DC/DC converter to recharge the capacitors in the ultracapacitor module. Prior art document US 2018/166892 A1 relates to a hybrid system that modifies a control algorithm such that the super-capacitor can not only supply pulsed power, but it now can also absorb pulsed power from the load while keeping the battery current constant such that the incoming pulsed power does not stress the battery. The absorbed energy is accumulated in the capacitor and then the control algorithm operates the DC/DC converter to recharge the battery with the energy from the capacitor at a rate that optimized battery performance. However, the current sourced from or provided to the capacitors in the ultracapacitor modules is not controlled and thus parameters like ESR and capacitance cannot be measured. It would be beneficial to develop an ultracapacitor module capable of measuring these parameters in order to assess the health/effectiveness of the ultracapacitor module.

**SUMMARY**

The present disclosure describes an ultra-capacitor module (UCM) according to claims 1 and 3, a vehicle electrical system according to claims 8 and 9, and a method of self-testing ultra-capacitor cells as part of an ultra-capacitor module according to claim 12.

**BRIEF DESCRIPTION OF THE DRAWINGS**

The ultracapacitor module will now be described, by way of example with reference to the accompanying drawings, in which:

FIG. 1 is a block diagram of a vehicular electrical system utilizing an ultracapacitor module (UCM) according to some embodiments.
FIG. 2 is a schematic diagram of system components of an ultracapacitor module according to some embodiments.
FIG. 3 is a flowchart illustrating vehicle level steps performed in monitoring parameter values associated with the UCM according to some embodiments.
FIG. 4 is a flowchart illustrating steps associated with generation of the charging profile according to some embodiments.
FIG. 5 is a graph illustrating the current waveform supplied by the DC-to-DC converter to the stack of ultra-capacitors and the voltages measured in response to the supplied current waveform according to some embodiments.

**DETAILED DESCRIPTION**

The present disclosure describes an ultracapacitor module (UCM) and in particular a system and method of a UCM capable of autonomously monitoring parameters of the ultracapacitor cells, such as equivalent series resistance (ESR) and capacitance. In some embodiments, the UCM utilizes a DC-to-DC converter connected in series between the ultra-capacitor cell stack and the vehicle voltage bus, which allows the UCM to control the current into and out of the ultra-capacitor cells for monitoring of one or more parameters associated with the ultra-capacitor cells (e.g., ESR, capacitance, state of health (SOH), state of charge (SOC), state of function (SOF), etc.

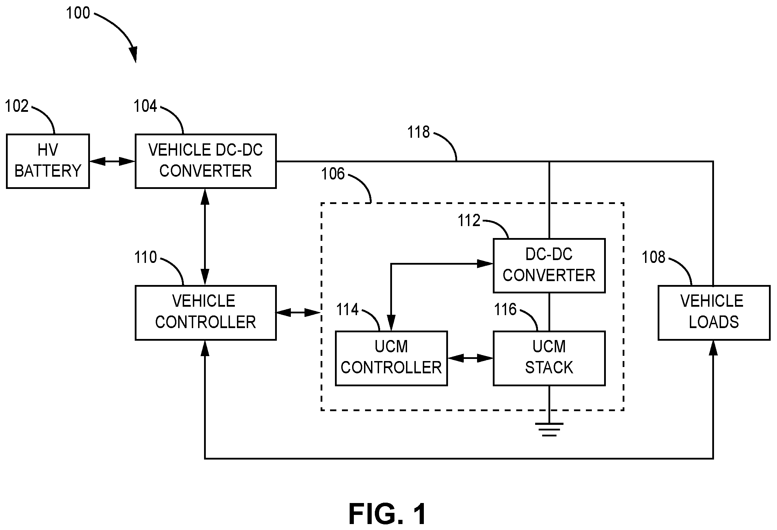

**FIG. 1** is a block diagram of a vehicular electrical system 100 utilizing an ultracapacitor module (UCM) 106 according to some embodiments. Vehicular electrical system 100 may include a high voltage (HV) battery 102, a vehicle DC-to-DC converter 104, and one or more vehicle loads 108 electrically connected via a voltage bus 118. In some embodiments, the UCM 106 includes a DC-to-DC converter 112, a UCM controller (e.g., digital signal processor (DSP)) 114, and an ultra-capacitor cell stack 116 having at least one ultra-capacitor cell. As shown in FIG. 1, the DC-to-DC converter 112 is connected in series between the ultra-capacitor cell stack 116 and the voltage bus 118. As described in more detail below, in some embodiments, DC-to-DC converter 112 is able to control the current supplied to (or from) the ultra-capacitor cell stack 116. As a result, the UCM 106 is able to autonomously generate the current waveforms required to measure one or more parameters of the ultra-capacitor cell stack 116, including equivalent series resistance (ESR) and capacitance. In some embodiments, HV battery 102 and vehicle DC-DC converter 104 make available on voltage bus 118 a sufficient amount of power for UCM 106 - in particular, DC-DC converter 112 - to generate the desired current waveforms for measuring the one or more parameters associated with the ultra-capacitor cell stack 116. In this embodiment, vehicle DC-DC converter 104 is not utilized to generate the desired current waveforms. In some embodiments, vehicle controller 110 may communicate bi-directionally with the UCM 106, including providing inputs utilized to initiate a parameter test and to receive the parameters measured or estimated by the UCM 106. In this way, UCM 106 is capable of autonomously generating the current waveforms required to measure the one or more parameters of the ultra-capacitor cell stack 116. It should be noted, that in other embodiments rather than UCM 106 autonomously measuring the one or more parameters of the ultra-capacitor cell stack 116, vehicle controller 110 may operate in conjunction with vehicle DC-to-DC converter 104 to generate the current waveforms required to measure the one or more parameters of the ultra-capacitor stack 116. In this embodiment, the DC-DC converter 112 included as part of the UCM 106 would not be required as vehicle DC-to-DC converter 104 would be responsible for generating the desired waveforms.

In the embodiment shown in **FIG. 1,** HV battery 102 supplies/draws power to/from the voltage bus 118 via vehicle DC-to-DC converter 104. Likewise, UCM 106 is configured to supply/draw power to/from the voltage bus 118. Vehicle loads 108 draw power from the voltage bus 118. In some embodiments, vehicle controller 110 communicates with vehicle DC-to-DC converter 104, UCM 106, and with vehicle loads 108. In some embodiments, communication is bidirectional and may include providing operational instructions to each component and/or receiving feedback (e.g., monitored parameters) from each component as part of a UCM test (e.g., measuring of ESR and/or capacitance). For example, as discussed in more detail below, before initiating a UCM test, the vehicle controller 110 may receive feedback regarding the status of the vehicle (in motion, stopped, etc.) as well as status from vehicle loads 108 regarding the current load status of the vehicle. In some embodiments, vehicle controller 110 may provide instructions to vehicle loads 108 to turn ON or OFF. For example, in some embodiments vehicle controller 110 may provide instructions to vehicle loads 108 instructing at least one of the vehicle loads to be turned ON to provide a discharge path for UCM 106 during one or more stages of the UCM test. In other embodiments, vehicle controller 110 may provide instructions to vehicle loads 108 to maintain one or more of the loads in the OFF state during one or more stages of the UCM test to ensure sufficient energy is available to UCM 106 during the test. Vehicle controller 110 may also provide instructions to vehicle DC-DC converter 104 instructing the DC-DC converter 104 to make sufficient power available to voltage bus 118 for conducting the UCM test. Vehicle controller 110 may also provide instructions to UCM 106 regarding initiation of the UCM test and may receive feedback regarding the measured results of the UCM test.

Although not shown in **FIG. 1,** in other embodiments, the vehicular electrical system 100 may include a number of other components, including a plurality of additional energy sources, including various types of batteries (e.g., AGM/Li ion), generator/alternators, etc., as well as various other vehicular loads. In some embodiments, the vehicle electrical system 100 may include a power distribution controller/switch utilized to control the distribution of power between the plurality of energy sources and the plurality of various loads. As described in more detail below, UCM 106 tests involve providing particular current waveforms to the UCM stack 116 and monitoring the response. One of the advantages of employing series connected DC-DC converter 112 included as part of the UCM 106 to test the parameters of the ultra-capacitor cell stack 116 is that DC-DC converter 112 is utilized to generate the particular current waveforms - rather than vehicle DC-DC converter 104. In some embodiments, relying on DC-DC converter 112 to generate the desired current waveforms reduces the error associated with the desired current waveform because the tolerances of the vehicle DC-DC converter 104 do not affect the current waveform generated by DC-DC converter 112. In some embodiments, the tolerances associated with DC-DC converter 112 may be lower than tolerances associated with vehicle DC-DC converter, further reducing error associated with the desired current waveform generated. However, in other embodiments the vehicle controller 110 could utilize the vehicle DC-DC converter 104 to provide the particular current waveforms to the UCM stack 116 and measure the response. In this embodiments, vehicle controller 110 may be configured to measure the responses to the current waveform provided and would not require UCM controller 114. That is, in this embodiment the UCM 106 is a passive UCM stack 116 and does not include components like UCM controller 114 and DC-DC converter 112 to actively control operation of the UCM 106.

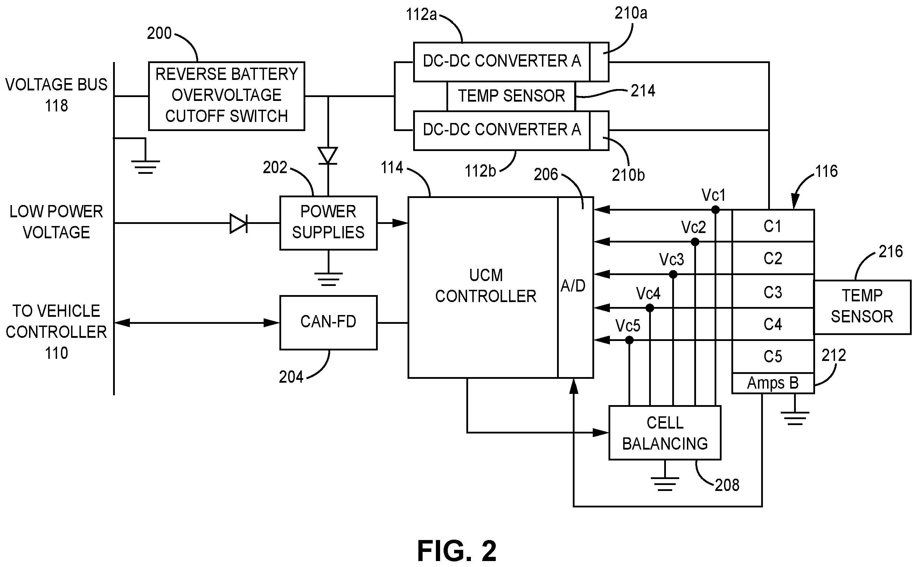

**FIG. 2** is a schematic diagram of system components of an ultracapacitor module (UCM) 106 according to some embodiments. In some embodiments, the UCM 106 includes first and second DC-to-DC converters 112a and 112b, UCM controller 114 (e.g., digital signal processor (DSP)) 114, and ultra-capacitor cell stack 116, which in this embodiment includes individual ultra-capacitor cells C1-C5. In addition, the UCM 106 includes a reverse battery overvoltage cutoff switch 200, power supply 202, communication input 204 (e.g., controller area network (CAN) bus flexible data (FD) input), analog-to-digital converter (ADC) 206, cell balancing circuit 208, current measurement sensors 210a, 210b, and 212, and temperature sensors 214 and 216. In some embodiments, temperature sensors 214 is utilized to monitor the temperature of DC-DC converters 112a, 112b, with temperature feedback being provided to UCM controller 114. Likewise, in some embodiments temperature sensor 216 is utilized to monitor the temperature of the ultra-capacitor cell stack 116, with temperature feedback being provided to UCM controller 114.

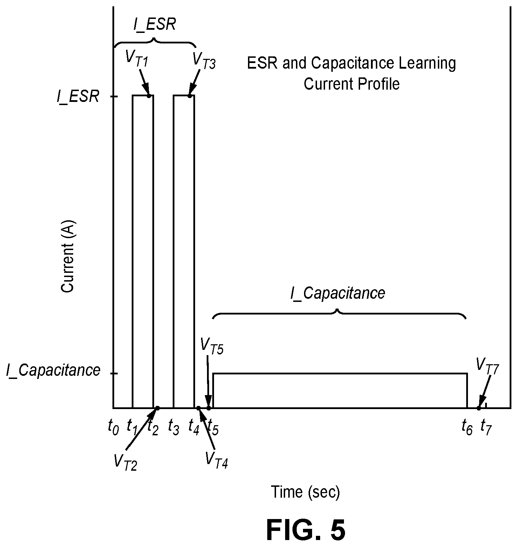

As shown in **FIG. 2,** both the first and second DC-to-DC converters 112a, 112b are connected in series between the voltage bus 118 and the ultra-capacitor cell stack 116. During parameter testing, the DC-to-DC converters 112a, 112b sources current having a desired current profile to the plurality of ultra-capacitor cells in the ultra-capacitor cell stack 116. In some embodiments, each DC-to-DC converter 112a, 112b includes a current measurement sensor 210a, 210b, respectively, utilized to measure the current provided to/from each DC-to-DC converter 112a, 112b to the plurality of ultra-capacitor cells C1-C5. In some embodiments, currents measured by current measurement sensors 210a, 210b are utilized by UCM controller 114 to balance the current provided by DC-to-DC converter 112a, 112b. In embodiments in which only a single DC-to-DC converter 112 is utilized, no current balancing is required. In some embodiments, UCM controller 114 monitors the current supplied to the plurality of ultra-capacitor cells C1-C5. In the embodiment shown in FIG. 2, current measurement sensor 212 is utilized to monitor the current provided by DC-to-DC converters 112a, 112b to the plurality of ultra-capacitor cells C1-C5. In some embodiments, the UCM controller 114 utilizes the current monitored by the current measurement sensor 212 in feedback to control the current profile sourced by the DC-DC converters 112a, 112b. In addition, the current monitored by the current measurement sensor 212 may be utilized in combination with other monitored parameters to calculate parameters such as ESR and capacitance. For example, FIG. 5 illustrates the desired current profile utilized to measure the ESR and capacitance of each of the plurality of ultra-capacitor cells C1-C5 according to some embodiments. The measurement tolerances associated with current sensors 210a, 210b, and 212 dictate the accuracy of the current profiles provided to the plurality of ultra-capacitor cells C1-C5. One of the benefits of the claimed invention is that only the tolerances of current sensors 210a, 210b, and 212 need to be taken into account for determining the accuracy of the measured parameters. In some embodiments, the current sensors 210a, 210b, and 212 utilized to monitor the currents sourced by the DC-to-DC converters 112a, 112b are calibrated during production of each UCM 106 to ensure accuracy.

In some embodiments, the UCM controller 114 is configured to monitor voltage at each of the plurality of ultra-capacitor cells C1-C5 via a plurality of voltage sensors ($V_{C1}$, $V_{C2}$, $V_{C3}$, $V_{C4}$, $V_{C5}$). ADC 206 converts the analog signals to a digital signal provided to UCM controller 114. In response to the current profile generated by the first and/or second DC-to-DC converters 112a, 112b, the plurality of voltage measurements are taken at various points within the applied current profile and utilized to calculate parameters such as ESR and capacitance.

In some embodiments, UCM controller 114 may communicate with vehicle controller 110 (shown in FIG. 1) via CAN-FD bus 204. Communication may include instructions provided by the vehicle controller 110 to initiate parameter testing, communications regarding whether conditions are optimal for parameter testing, etc. In addition, UCM controller 114 may provide feedback to the vehicle controller 110 regarding monitored parameters (e.g., ESR, capacitance, SOH, and others). In some embodiments, vehicle controller 110 utilizes the monitored parameters to determine the health of the UCM 106 and may generate alerts if the health of the UCM 106 falls below a threshold level.

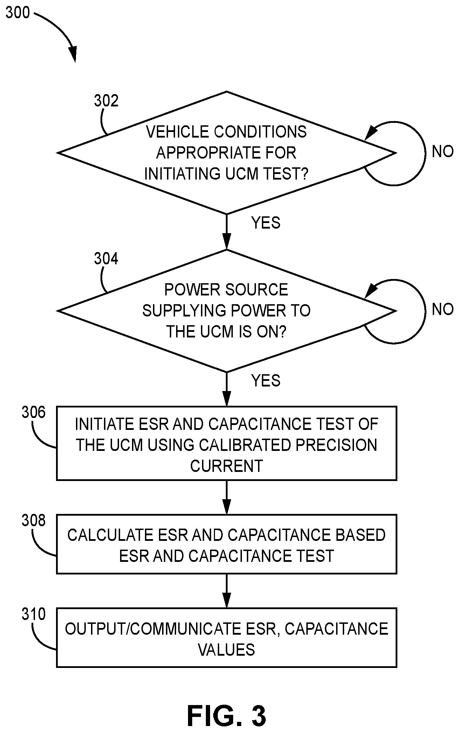

**FIG. 3** is a flow chart illustrating vehicle level steps performed in monitoring parameter values associated with the UCM 106 according to some embodiments. At step 302 the vehicle controller 110 determines whether vehicle conditions are appropriate for initiating a UCM test. In some embodiments, the vehicle should be at rest before initiating the UCM test. In some embodiments, the vehicle should not be using energy on the voltage bus 118 connected to the UCM 106 (e.g., vehicle loads should not be operating). If these conditions are not met, then vehicle controller 110 continues monitoring at step 302 until the conditions are satisfied. If the vehicle conditions are met, then the process continues at step 304.

At step 304 the vehicle controller 110 determines whether the power source providing power to the UCM 106 is turned ON and is supplying sufficient power to support the DC-to-DC converters 112a, 112b in supplying the desired current profile to the ultra-capacitor cell stack 116. With respect to the embodiment shown in **FIG. 1,** this would include vehicle controller 110 providing instructions to turn ON the vehicle DC-DC converter 104 and providing instructions to vehicle DC-DC converter 104 to provide power/current to the voltage bus 118 sufficient to conduct the UCM test. In some embodiments, other parameters may be monitored, such as voltage provided on voltage bus 118 to ensure sufficient power is available to the DC-to-DC converter 112a, 112b. If the vehicle DC-DC converter 104 is unable to provide the desired power/current onto the voltage bus 118, then monitoring continues at step 304 (or in some embodiments, at step 302) until conditions are sufficient to support the desired current profile.

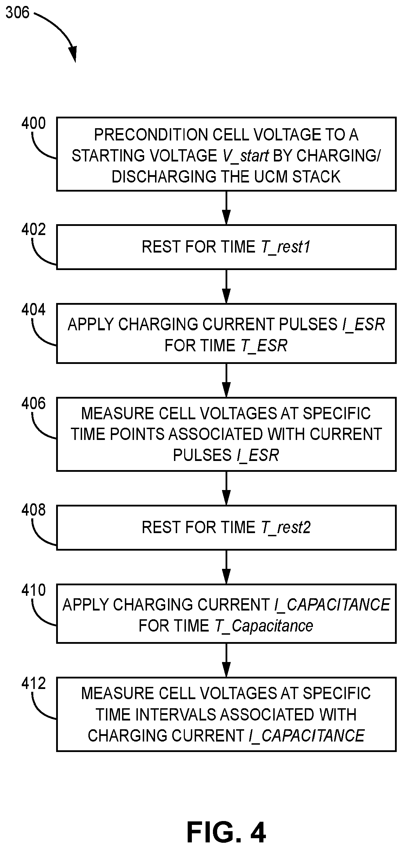

At step 306 the ESR and capacitance test is initiated by the vehicle controller 110. In some embodiments, this includes communicating instructions to the UCM controller 114 associated with the UCM 106 instructing the UCM controller 114 to initiate the ESR/capacitance test. In some embodiments, the ESR/capacitance test requires sourcing via DC-to-DC converter 112a, 112b a desired current profile provided to the ultra-capacitor cell stack 116. As described in more detail in FIGS. 4 and 5, measurements are taken in response to the current profile generated including a plurality of voltages measured at specific intervals throughout the applied current profile.

At step 308 one or more parameters are measured based on the measurements collected in response to the applied current profile. For example, in some embodiments the one or more parameters include equivalent series resistance (ESR) and/or capacitance. In some embodiments, the ESR/capacitance measurements are made with respect to each individual ultra-capacitor cell C1-C5. In some embodiments, the ESR/capacitance measurements are made with respect to the stack of ultra-capacitor cells. In addition, in some embodiments the measured parameters include additional parameters such as state of charge (SOC), state of health (SOH), and state of function (SOF).

At step 310 the one or more of the estimated or measured parameters (e.g., ESR/capacitance, SOH, SOC, etc.) are communicated from UCM 106 to the vehicle controller 110. In some embodiments, vehicle controller 110 may generate alerts or displays in response to the one or more estimated parameters.

As described above, in some embodiments the UCM 106 is a passive component and does not include a UCM controller 114 and/or DC-DC converter 112. In this embodiment, the vehicle controller 110 may operate in conjunction with vehicle DC-to-DC converter 104 to perform the steps outlined in **FIG. 3** to generate the current waveforms required and to measure the one or more parameters of the ultra-capacitor stack 116.

**FIG. 4** is a flowchart illustrating steps associated with the initiation of the ESR and capacitance test of the UCM using a calibrated precision current (step 306 in FIG. 3) according to some embodiments. In some embodiments, the steps described in **FIG. 4** are performed on a cell-by-cell basis and may be performed one at a time. In other embodiments, each of the plurality of cells are analyzed simultaneously. The current profile sourced by the DC-to-DC converter 112 to the plurality of series-connected ultra-capacitor cells is equal at each cell because the plurality of ultra-capacitors cells are stacked in series with one another.

At step 400 the ultra-capacitor cell voltage is preconditioned to a starting voltage $V\_start$ by selectively charging/discharging the ultra-capacitor cell stack. For example, in one embodiment the ultra-capacitor cell voltage $V\_start$ is set equal to value of approximately 1.7V. In some embodiments, preconditioning each of the plurality of cell voltages to a desired starting voltage may require DC-to-DC converter 112 to provide current to the ultra-capacitor cell stack 116 (shown in FIGS. 1 and 2) or receive current from the ultra-capacitor cell stack 116 depending on the initial voltages associated with each ultra-capacitor cell. In some embodiments, balancing of the cell voltages may further require operation of cell balancing circuit 208 (shown in FIG. 2) based on a comparison of the cell voltages associated with each of the plurality of ultra-capacitor cells.

At step 402, DC-to-DC converter 112 rests for a time period (designated $T\_rest1$). During the rest time period, no current is sourced by the DC-to-DC converter 112. For example, in one embodiment the rest period $T\_rest1$ is equal to 2.5 seconds.

At step 404, a charging current profile $I\_ESR$ is sourced by the DC-to-DC converter 112 for a given time period (designated $T\_ESR$). For example, FIG. 5 illustrates an exemplary current profile $I\_ESR$ applied between times $t1$ and $t4,$ consisting of a number of current pulses having a first magnitude ($I\_ESR\_magnitude$). For example, in one embodiment the first magnitude of the current pulses is equal to 30A. In the embodiment shown in FIG. 5, the charging current profile $I\_ESR$ comprises two current pulses, but in other embodiments additional numbers of current pulses may be applied.

At step 406, cell voltages are measures at specific time points associated with the current charging current profile $I\_ESR$. In some embodiments, cell voltages are measured with respect to each of the plurality of ultra-capacitor cells C1-C5. For purposes of this example, voltage measurements are described with respect to the point in time at which they were collected, but it should be noted that voltage measurements may be collected for each of the plurality of ultra-capacitor cells C1-C5. For example, as shown in FIG. 5, voltages $V_{T1}$, $V_{T3}$ are measured right before the current pulses end (just before times $t2$ and $t4$ shown in FIG. 5). Voltages $V_{T2}$ and $V_{T4}$ are measured right after the current pulses end (just after times $t2$ and $t4$ shown in FIG. 5). These voltage measurements may be taken with respect to each of the plurality of ultra-capacitor cells C1-C5. The equivalent series resistance (ESR) is estimated based on the following equations:

$$ESR = (V_{T1} - V_{T2})/I\_ESR\_magnitude \qquad (1)$$

OR

$$ESR = (V_{T3} - V_{T4})/I\_ESR\_magnitude \qquad (2)$$

In some embodiments, the ESR values may be estimated using both equations (1) and (2) and averaging the results. In other embodiments, a low-pass filter is applied to ESR estimations collected over a period of time. An ESR value may be measured for each of the plurality of ultra-capacitor cells C1-C5.

At step 408, DC-to-DC converter 112 rests for a time period (designated $T\_rest2$). During the rest time period, no current is sourced by the DC-to-DC converter 112. For example, in one embodiment the rest period $T\_rest2$ is equal to 2.5 seconds. In the embodiment shown in **FIG. 5** the time period $T\_rest2$ is provided between times $t4$ and $t5$.

At step 410 a charging current profile $I\ Capacitance$ is sourced by the DC-to-DC converter 112 for a given time period (designated $T\_capacitance$). For example, FIG. 5 illustrates an exemplary current profile $I\_Capacitance$ applied between times $t5$ and $t6$, consisting of a long current pulse having a second magnitude ($I\_Capacitance\_magnitude$) less than the first magnitude ($I\_ESR\_magnitude$). For example, in one embodiment the magnitude of the longer current pulse is equal to 3.25A and has a length or time of approximately 32 seconds. As compared with the current profile $I\_ESR,$ the current profile of $I\_Capacitance$ is longer in duration and has a lower magnitude.

At step 412 cell voltages are measured at specific points in time associated with the current profile $I\_Capacitance.$ Once again, cell voltages are measured with respect to each of the plurality of ultra-capacitor cells C1-C5. For purposes of this example, voltage measurements are described with respect to the point in time at which they were collected, but it should be noted that voltage measurements may be collected for each of the plurality of ultra-capacitor cells C1-C5. For example, as shown in **FIG. 5,** voltage $V_{T5}$ is measured right before the current profile $I\_Capacitance$ is applied (just before time $t5$ as shown in FIG. 5) and voltage $V_{T7}$ is measured after the current profile $I\_Capacitance$ has been removed and cell voltage has relaxed for a resting period $T\_rest3$ (e.g., time $t7$ in FIG. 5). In some embodiments, the resting period $T\_rest3$ is equal to the other resting periods $T\_rest1$ and $T\_rest2$ (e.g., 2.5 seconds), although in other embodiments different resting times may be selected. As before, these voltage measurements may be taken with respect to each of the plurality of ultra-capacitor cells C1-C5. The capacitance is calculated as follows:

$$CAPACITANCE = \frac{\int_{t5}^{t6} I\_Capacitance\, dt}{V_{t7} - V_{t5}} \tag{3}$$

In some embodiments, the ESR and capacitance values calculated in response to the current sourced by the DC-to-DC converter 112 provides a good indication of the state of health of each individual cell. For example, an increase in ESR (e.g., increase of 100% or more) or a decay in cell capacitance (e.g., decrease of 20% or more), the cell may be identified as entering end of life.

While the invention has been described with reference to an exemplary embodiment(s), it will be understood by those skilled in the art that various changes may be made, without departing from the scope of the invention. In addition, many modifications may be made to adapt a particular situation or material to the teachings of the invention without departing from the scope thereof. Therefore, it is intended that the invention is not limited to the disclosed embodiment(s), but that the invention will include all embodiments falling within the scope of the appended claims.

As used herein, 'one or more' includes a function being performed by one element, a function being performed by more than one element, e.g., in a distributed fashion, several functions being performed by one element, several functions being performed by several elements, or any combination of the above.

It will also be understood that, although the terms first, second, etc. are, in some instances, used herein to describe various elements, these elements should not be limited by these terms. These terms are only used to distinguish one element from another. For example, a first contact could be termed a second contact, and, similarly, a second contact could be termed a first contact, without departing from the scope of the various described embodiments. The first contact and the second contact are both contacts, but they are not the same contact.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if" is, optionally, construed to mean "when" or "upon" or "in response to determining" or "in response to detecting," depending on the context. Similarly, the phrase "if it is determined" or "if [a stated condition or event] is detected" is, optionally, construed to mean "upon determining" or "in response to determining" or "upon detecting [the stated condition or event]" or "in response to detecting [the stated condition or event]," depending on the context.

Additionally, while terms of ordinance or orientation may be used herein these elements should not be limited by these terms. All terms of ordinance or orientation, unless stated otherwise, are used for purposes distinguishing one element from another, and do not denote any particular order, order of operations, direction or orientation unless stated otherwise.

**Claims**

1.  An ultra-capacitor module, UCM (106), comprising:

    a DC-to-DC converter (112, 112a, 112b);
    a plurality of ultra-capacitor cells (116, C1-C5) connected to receive power from and source power to the DC-to-DC converter (112, 112a, 112b); and
    a UCM controller (114) configured to monitor a current generated by the DC-to-DC converter (112, 112a, 112b) and a voltage associated with each of the plurality of ultra-capacitor cells (116, C1-C5) and controls the DC-to-DC converter (112, 112a, 112b) based on the monitored current to generate a current profile and utilizes the monitored voltages to measure one or more parameters associated with each of the plurality of ultra-capacitor cells (C1-C5) and/or with the plurality of ultra-capacitor cells (116), **characterised in that**
    the one or more parameters includes effective series resistance, ESR, and/or capacitance, and
    **in that** the ESR is calculated for each of the plurality of ultra-capacitor cells (C1-C5) by measuring the voltage associated with each of the plurality of ultra-capacitor cells (C1-C5) at specific points associated with the charging profile, wherein the charging profile utilized to measure the ESR includes a plurality of current pulses.

2.  The UCM (106) of claim 1, wherein the ESR is calculated based on the equation:

$$ESR = \frac{V_{T1} - V_{T2}}{I\_ESR\_magnitude}$$

    wherein $V_{T1}$ is voltage measured right before a current pulse associated with the charging profile ends and $V_{T2}$ is a voltage measured right after the current pulse associated with the charging profile ends, wherein $I\_ESR\_magnitude$ is a magnitude of the current pulse.

3.  An ultra-capacitor module, UCM (106), comprising:

    a DC-to-DC converter (112, 112a, 112b);
    a plurality of ultra-capacitor cells (116, C1-C5) connected to receive power from and source power to the DC-to-DC converter (112, 112a, 112b); and
    a UCM controller (114) configured to monitor a current generated by the DC-to-DC converter (112, 112a, 112b) and a voltage associated with each of the plurality of ultra-capacitor cells (116, C1-C5) and controls the DC-to-DC converter (112, 112a, 112b) based on the monitored current to generate a current profile and utilizes the monitored voltages to measure one or more parameters associated with each of the plurality of ultra-capacitor cells (C1-C5) and/or with the plurality of ultra-capacitor cells (116), **characterised in that**
    the one or more parameters includes effective series resistance, ESR, and/or capacitance, and
    **in that** the capacitance is calculated for each of the plurality of ultra-capacitor cells (C1-C5) by measuring the voltage associated with each of the plurality of ultra-capacitor cells (C1-C5) at specific points associated with the charging profile, wherein the charging profile utilize to measure the capacitance includes a single current pulse having a determined duration.

4.  The UCM (106) of claim 3, wherein the capacitance is calculated based on the equation:

$$CAPACITANCE = \frac{\int_{t5}^{t6} I\_Capacitance\, dt}{V_{t7} - V_{t5}}$$

    wherein $V_{t7}$ is voltage measured a time period following the single current pulse and $V_{t5}$ is a voltage measured right before the single current pulse is delivered, wherein $I\_Capacitance$ is the current profile associated with the single current pulse.

5.  The UCM (106) of any preceding claim, further including a current sensor (210a, 210b, 212) utilized to measure the current generated by the DC-to-DC converter (112, 112a, 112b), wherein the current sensor (210a, 210b, 212) measures the current provided by the DC-to-DC converter (112, 112a, 112b) to the plurality of ultra-capacitor cells (116, C1-C5).

6. The UCM (106) of claim 5, wherein the UCM controller utilizes the current measured by the current sensor (210a, 210b, 212) to control operation of the DC-to-DC converter (112, 112a, 112b) to deliver the current profile and utilizes the current measured by the current sensor (210a, 210b, 212) to calculate ESR and/or capacitance associated with each of the plurality of ultra-capacitor cells (C1-C5).

7. The UCM (106) of any one of the preceding claims, wherein the UCM controller (114) initiates measurement of the one or more parameters in response to communication indicating that vehicle conditions are proper.

8. A vehicle electrical system (100) comprising:

   a voltage bus (118);
   a vehicle DC-to-DC converter (104) coupled between a vehicle power source (102) and the voltage bus (118) and configured to provide power to/from the voltage bus (118) bi-directionally;
   a vehicle load (108) coupled to the voltage bus (118) and configured to receive power from the voltage bus (118);
   an ultra-capacitor module, UCM (106), coupled to the voltage bus (118), wherein the UCM (106) provides power to/from the voltage bus (118) bi-directionally, the UCM (106) comprising:

   a plurality of ultra-capacitor cells (116, C1-C5);
   a DC-to-DC converter (112, 112a, 112b) connected in series between the voltage bus (118) and the plurality of ultra-capacitor cells (116, C1-C5); and
   a UCM controller (114) configured to initiate a UCM self-test, wherein the UCM controller (114) causes the DC-to-DC converter (112, 112a, 112b) to source a selected current profile to the plurality of ultra-capacitor cells (116, C1-C5) and measures one or more parameters associated with each of the plurality of ultra-capacitor cells (116, C1-C5), the UCM controller (114) measures effective series resistance, ESR, and/or capacitance of the plurality of ultra-capacitor cells (116, C1-C5) based on the measured parameters; and a vehicle controller (110) configured to communicate with the vehicle DC-to-DC converter (104), the vehicle load (108), and the UCM (106), wherein the vehicle controller (110) provides instructions to the UCM controller (114) to initiate the UCM self-test, **characterised in that** the vehicle controller receives in response the measured ESR and/or capacitance associated with each of the plurality of ultra-capacitor cells (C1-C5), and

   **in that** the ESR is calculated for each of the plurality of ultra-capacitor cells (C1-C5) by measuring the voltage associated with each of the plurality of ultra-capacitor cells (C1-C5) at specific points associated with the charging profile, wherein the charging profile utilized to measure the ESR includes a plurality of current pulses.

9. A vehicle electrical system (100) comprising:

   a voltage bus (118);
   a vehicle DC-to-DC converter (104) coupled between a vehicle power source (102) and the voltage bus (118) and configured to provide power to/from the voltage bus (118) bi-directionally;
   a vehicle load (108) coupled to the voltage bus (118) and configured to receive power from the voltage bus (118);
   an ultra-capacitor module, UCM (106), coupled to the voltage bus (118), wherein the UCM (106) provides power to/from the voltage bus (118) bi-directionally, the UCM (106) comprising:

   a plurality of ultra-capacitor cells (116, C1-C5);
   a DC-to-DC converter (112, 112a, 112b) connected in series between the voltage bus (118) and the plurality of ultra-capacitor cells (116, C1-C5); and
   a UCM controller (114) configured to initiate a UCM self-test, wherein the UCM controller (114) causes the DC-to-DC converter (112, 112a, 112b) to source a selected current profile to the plurality of ultra-capacitor cells (116, C1-C5) and measures one or more parameters associated with each of the plurality of ultra-capacitor cells (116, C1-C5), the UCM controller (114) measures effective series resistance, ESR, and/or capacitance of the plurality of ultra-capacitor cells (116, C1-C5) based on the measured parameters; and a vehicle controller (110) configured to communicate with the vehicle DC-to-DC converter (104), the vehicle load (108), and the UCM (106), wherein the vehicle controller (110) provides instructions to the UCM controller (114) to initiate the UCM self-test, **characterised in that** the vehicle controller receives in response the measured ESR and/or capacitance associated with each of the plurality of ultra-capacitor cells (C1-C5), and

**in that** the capacitance is calculated for each of the plurality of ultra-capacitor cells (C1-C5) by measuring the voltage associated with each of the plurality of ultra-capacitor cells (C1-C5) at specific points associated with the charging profile, wherein the charging profile utilize to measure the capacitance includes a single current pulse having a determined duration.

10. The vehicle electrical system (100) of any one of claims 8 or 9, wherein the vehicle controller (110) initiates a UCM self-test in response to one or more conditions being met.

11. The vehicle electrical system (100) of any one of claims 8-10, wherein the one or more conditions include confirmation received from the vehicle DC-to-DC converter (104) that sufficient power/current is available for the UCM (106) to conduct the UCM self-test or in response to the vehicle being at rest and/or wherein the vehicle controller (110) initiates a UCM self-test in response to status of the vehicle loads (108).

12. A method of self-testing ultra-capacitor cells (116, C1-5) included as part of an ultra-capacitor module, UCM (106), the method comprising:

sourcing from a DC-DC converter (104, 112, 112a, 112b) a charging current $I\_ESR$ comprised of a plurality of current pulses to the plurality of ultra-capacitor cells (116, C1-C5) (step 306, step 404);
measuring voltages across one or more of the plurality of ultra-capacitor cells at specific points in time with respect to the charging current $I\_ESR$ (step 306, step 406);
calculating an effective series resistance, ESR, of one or more of the plurality of ultra-capacitor cells based on the voltages measured at specific points in time and a magnitude of the charging current $I\_ESR$ (step 308);
sourcing from the DC-DC converter (104, 112, 112a, 112b) a charging current $I\_capacitance$ comprised of a single current pulse to the plurality of ultra-capacitor cells (116, C1-C5) (step 306, step 410);
measuring voltages across one or more of the plurality of ultra-capacitor cells (116, C1-C5) at specific points in time with respect to the charging current $I\_capacitance;$ (step 306, step 412) and
calculating a capacitance of one or more of the plurality of ultra-capacitor cells (116, C1, C5) based on the voltages measured at specific points in time and a magnitude of the charging current $I\_capacitance$ (step 308).

13. The method of claim 12, wherein the ESR is calculated based on the equation:

$$ESR = \frac{V_{T1} - V_{T2}}{I\_ESR\_magnitude}$$

wherein $V_{T1}$ is voltage measured right before a current pulse associated with the charging current $I\_ESR$ ends and $V_{T2}$ is a voltage measured right after the current pulse associated with the charging current $I\_ESR$ ends, wherein $I\_ESR\_magnitude$ is a magnitude of the current pulse.

14. The method of claim 12 or 13, wherein the capacitance is calculated based on the equation:

$$Capacitance = \frac{\int_{t5}^{t6} I\_Capacitance\, dt}{V_{t7} - V_{t5}}$$

wherein $V_{t7}$ is voltage measured a time period following the single current pulse and $V_{t5}$ is a voltage measured right before the single current pulse is delivered, wherein $I\_Capacitance$ is the charging current sourced from the DC-DC converter (104, 112, 112a, 112b) consisting of a single pulse that extends from time $t5$ to time $t6$.

**Patentansprüche**

1. Ultrakondensatormodul, UCM, (106), umfassend:

einen DC-DC-Wandler (112, 112a, 112b);
eine Vielzahl von Ultrakondensatorzellen (116, C1-C5), die verbunden sind, um Leistung von dem DC-DC-Wandler (112, 112a, 112b) zu empfangen und Leistung an diesen zu liefern; und
eine UCM-Steuerung (114), die konfiguriert ist, um einen durch den DC-DC-Wandler (112, 112a, 112b) erzeugten Strom und eine jeder der Vielzahl von Ultrakondensatorzellen (116, C1-C5) zugeordnete Spannung zu überwachen, und den DC-DC-Wandler (112, 112a, 112b) basierend auf dem überwachten Strom steuert, um ein Stromprofil zu erzeugen, und die überwachten Spannungen verwendet, um einen oder mehrere Parameter zu messen, die jeder der Vielzahl von Ultrakondensatorzellen (C1-C5) und/oder der Vielzahl von Ultrakondensatorzellen (116) zugeordnet sind, **dadurch gekennzeichnet, dass**
der eine oder die mehreren Parameter einen effektiven Reihenwiderstand, ESR, und/oder eine Kapazität beinhalten, und dadurch, dass
der ESR für jede der Vielzahl von Ultrakondensatorzellen (C1-C5) berechnet wird, indem die jeder der Vielzahl von Ultrakondensatorzellen (C1-C5) zugeordnete Spannung an spezifischen Punkten gemessen wird, die dem Ladeprofil zugeordnet sind, wobei das zum Messen des ESR verwendete Ladeprofil eine Vielzahl von Stromimpulsen beinhaltet.

2. UCM (106) nach Anspruch 1, wobei der ESR basierend auf der folgenden Gleichung berechnet wird:

$$ESR = \frac{V_{T1} - V_{T2}}{I\_ESR\_magnitude}$$

wobei $VT_1$ eine Spannung ist, die unmittelbar vor dem Ende eines dem Ladeprofil zugeordneten Stromimpulses gemessen wird, und $VT_2$ eine Spannung ist, die unmittelbar nach dem Ende des dem Ladeprofil zugeordneten Stromimpulses gemessen wird, wobei $I\_ESR\_magnitude$ eine Magnitude des Stromimpulses ist.

3. Ultrakondensatormodul, UCM, (106), umfassend:

einen DC-DC-Wandler (112, 112a, 112b);
eine Vielzahl von Ultrakondensatorzellen (116, C1-C5), die verbunden sind, um Leistung von dem DC-DC-Wandler (112, 112a, 112b) zu empfangen und Leistung an diesen zu liefern; und
eine UCM-Steuerung (114), die konfiguriert ist, um einen durch den DC-DC-Wandler (112, 112a, 112b) erzeugten Strom und eine jeder der Vielzahl von Ultrakondensatorzellen (116, C1-C5) zugeordnete Spannung zu überwachen, und den DC-DC-Wandler (112, 112a, 112b) basierend auf dem überwachten Strom steuert, um ein Stromprofil zu erzeugen, und die überwachten Spannungen verwendet, um einen oder mehrere Parameter zu messen, die jeder der Vielzahl von Ultrakondensatorzellen (C1-C5) und/oder der Vielzahl von Ultrakondensatorzellen (116) zugeordnet sind, **dadurch gekennzeichnet, dass**
der eine oder die mehreren Parameter einen effektiven Reihenwiderstand, ESR, und/oder eine Kapazität beinhalten, und dadurch, dass
die Kapazität für jede der Vielzahl von Ultrakondensatorzellen (C1-C5) berechnet wird, indem die jeder der Vielzahl von Ultrakondensatorzellen (C1-C5) zugeordnete Spannung an spezifischen Punkten gemessen wird, die dem Ladeprofil zugeordnet sind, wobei das zum Messen der Kapazität verwendete Ladeprofil einen einzelnen Stromimpuls mit einer bestimmten Dauer beinhaltet.

4. UCM (106) nach Anspruch 3, wobei die Kapazität basierend auf der folgenden Gleichung berechnet wird:

$$CAPACITANCE = \frac{\int_{t5}^{t6} I\_Capacitance\,dt}{V_{t7} - V_{t5}}$$

wobei $Vt_7$ eine Spannung ist, die in einem Zeitraum nach dem einzelnen Stromimpuls gemessen wird, und $Vt_5$ eine Spannung ist, die unmittelbar vor der Abgabe des einzelnen Stromimpulses gemessen wird, wobei $I\_Capacitance$ das dem einzelnen Stromimpuls zugeordnete Stromprofil ist.

5. UCM (106) nach einem der vorhergehenden Ansprüche, ferner beinhaltend einen Stromsensor (210a, 210b, 212), der verwendet wird, um den durch den DC-DC-Wandler (112, 112a, 112b) erzeugten Strom zu messen, wobei der Stromsensor (210a, 210b, 212) den durch den DC-DC-Wandler (112, 112a, 112b) an die Vielzahl von Ultrakondensatorzellen (116, C1-C5) gelieferten Strom misst.

6. UCM (106) nach Anspruch 5, wobei die UCM-Steuerung den durch den Stromsensor (21oa, 210b, 212) gemessenen Strom verwendet, um den Betrieb des DC-DC-Wandlers (112, 112a, 112b) zu steuern, um das Stromprofil abzugeben, und den durch den Stromsensor (210a, 210b, 212) gemessenen Strom verwendet, um den ESR und/oder die jeder der Vielzahl von Ultrakondensatorzellen (C1-C5) zugeordnete Kapazität zu berechnen.

7. UCM (106) nach einem der vorhergehenden Ansprüche, wobei die UCM-Steuerung (114) die Messung des einen oder der mehreren Parameter als Reaktion auf eine Kommunikation einleitet, die angibt, dass die Fahrzeugbedingungen angemessen sind.

8. Elektrisches Fahrzeugsystem (100), umfassend:

einen Spannungsbus (voltage bus) (118);
einen Fahrzeug-DC-DC-Wandler (104), der zwischen eine Fahrzeugleistungsquelle (102) und den Spannungsbus (118) gekoppelt ist und konfiguriert ist, um Leistung bidirektional an den/von dem Spannungsbus (118) bereitzustellen;
eine Fahrzeuglast (108), die an den Spannungsbus (118) gekoppelt ist und konfiguriert ist, um Leistung von dem Spannungsbus (118) zu empfangen;
ein Ultrakondensatormodul, UCM, (106), das an den Spannungsbus (118) gekoppelt ist, wobei das UCM (106) Leistung bidirektional an den/von dem Spannungsbus (118) bereitstellt, wobei das UCM (106) umfasst:

eine Vielzahl von Ultrakondensatorzellen (116, C1-C5);
einen DC-DC-Wandler (112, 112a, 112b), der in Reihe zwischen den Spannungsbus (118) und die Vielzahl von Ultrakondensatorzellen (116, C1-C5) geschaltet ist; und
eine UCM-Steuerung (114), die konfiguriert ist, um einen UCM-Selbsttest einzuleiten, wobei die UCM-Steuerung (114) bewirkt, dass der DC-DC-Wandler (112, 112a, 112b) ein ausgewähltes Stromprofil an die Vielzahl von Ultrakondensatorzellen (116, C1-C5) liefert und einen oder mehrere Parameter misst, die jeder der Vielzahl von Ultrakondensatorzellen (116, C1-C5) zugeordnet sind, wobei die UCM-Steuerung (114) einen effektiven Reihenwiderstand, ESR, und/oder eine Kapazität der Vielzahl von Ultrakondensatorzellen (116, C1-C5) basierend auf den gemessenen Parametern misst; und

eine Fahrzeugsteuerung (110), die konfiguriert ist, um mit dem Fahrzeug-DC-DC-Wandler (104), der Fahrzeuglast (108) und dem UCM (106) zu kommunizieren, wobei die Fahrzeugsteuerung (110) Anweisungen an die UCM-Steuerung (114) bereitstellt, um den UCM-Selbsttest einzuleiten, **dadurch gekennzeichnet, dass** die Fahrzeugsteuerung als Reaktion den gemessenen ESR und/oder die Kapazität, die jeder der Vielzahl von Ultrakondensatorzellen (C1-C5) zugeordnet sind, empfängt, und dadurch, dass der ESR für jede der Vielzahl von Ultrakondensatorzellen (C1-C5) berechnet wird, indem die jeder der Vielzahl von Ultrakondensatorzellen (C1-C5) zugeordnete Spannung an spezifischen Punkten gemessen wird, die dem Ladeprofil zugeordnet sind, wobei das zum Messen des ESR verwendete Ladeprofil eine Vielzahl von Stromimpulsen beinhaltet.

9. Elektrisches Fahrzeugsystem (100), umfassend:

einen Spannungsbus (118);
einen Fahrzeug-DC-DC-Wandler (104), der zwischen eine Fahrzeugleistungsquelle (102) und den Spannungsbus (118) gekoppelt ist und konfiguriert ist, um Leistung bidirektional an den/von dem Spannungsbus (118) bereitzustellen;
eine Fahrzeuglast (108), die an den Spannungsbus (118) gekoppelt ist und konfiguriert ist, um Leistung von dem Spannungsbus (118) zu empfangen;
ein Ultrakondensatormodul, UCM, (106), das an den Spannungsbus (118) gekoppelt ist, wobei das UCM (106) Leistung bidirektional an den/von dem Spannungsbus (118) bereitstellt, wobei das UCM (106) umfasst:

eine Vielzahl von Ultrakondensatorzellen (116, C1-C5);
einen DC-DC-Wandler (112, 112a, 112b), der in Reihe zwischen den Spannungsbus (118) und die Vielzahl von Ultrakondensatorzellen (116, C1-C5) geschaltet ist; und
eine UCM-Steuerung (114), die konfiguriert ist, um einen UCM-Selbsttest einzuleiten, wobei die UCM-Steuerung (114) bewirkt, dass der DC-DC-Wandler (112, 112a, 112b) ein ausgewähltes Stromprofil an die Vielzahl von Ultrakondensatorzellen (116, C1-C5) liefert und einen oder mehrere Parameter misst, die jeder der Vielzahl von Ultrakondensatorzellen (116, C1-C5) zugeordnet sind, wobei die UCM-Steuerung (114) einen effektiven Reihenwiderstand, ESR, und/oder eine Kapazität der Vielzahl von Ultrakondensatorzellen (116, C1-C5) basierend auf den gemessenen Parametern misst; und

eine Fahrzeugsteuerung (110), die konfiguriert ist, um mit dem Fahrzeug-DC-DC-Wandler (104), der Fahrzeuglast (108) und dem UCM (106) zu kommunizieren, wobei die Fahrzeugsteuerung (110) Anweisungen an die UCM-Steuerung (114) bereitstellt, um den UCM-Selbsttest einzuleiten, **dadurch gekennzeichnet, dass** die Fahrzeugsteuerung als Reaktion den gemessenen ESR und/oder die Kapazität, die jeder der Vielzahl von Ultrakondensatorzellen (C1-C5) zugeordnet sind, empfängt, und dadurch, dass

die Kapazität für jede der Vielzahl von Ultrakondensatorzellen (C1-C5) berechnet wird, indem die jeder der Vielzahl von Ultrakondensatorzellen (C1-C5) zugeordnete Spannung an spezifischen Punkten gemessen wird, die dem Ladeprofil zugeordnet sind, wobei das zum Messen der Kapazität verwendete Ladeprofil einen einzelnen Stromimpuls mit einer bestimmten Dauer beinhaltet.

10. Elektrisches Fahrzeugsystem (100) nach einem der Ansprüche 8 oder 9, wobei die Fahrzeugsteuerung (110) einen UCM-Selbsttest als Reaktion darauf einleitet, dass eine oder mehrere Bedingungen erfüllt sind.

11. Elektrisches Fahrzeugsystem (100) nach einem der Ansprüche 8-10, wobei die eine oder mehreren Bedingungen eine Bestätigung beinhalten, die von dem Fahrzeug-DC-DC-Wandler (104) empfangen wird, dass ausreichend Leistung/Strom für das UCM (106) verfügbar ist, um den UCM-Selbsttest durchzuführen, oder als Reaktion darauf, dass das Fahrzeug in Ruhe ist, und/oder wobei die Fahrzeugsteuerung (110) einen UCM-Selbsttest als Reaktion auf den Status der Fahrzeuglasten (108) einleitet.

12. Verfahren zum Selbsttesten von Ultrakondensatorzellen (116, C1-5), die als Teil eines Ultrakondensatormoduls, UCM, (106) beinhaltet sind, wobei das Verfahren Folgendes umfasst:

Liefern eines Ladestroms I_ESR, der aus einer Vielzahl von Stromimpulsen besteht, von einem DC-DC-Wandler (104, 112, 112a, 112b) an die Vielzahl von Ultrakondensatorzellen (116, C1-C5) (Schritt 306, Schritt 404);
Messen von Spannungen über eine oder mehrere der Vielzahl von Ultrakondensatorzellen zu spezifischen Zeitpunkten in Bezug auf den Ladestrom I_ESR (Schritt 306, Schritt 406);
Berechnen eines effektiven Reihenwiderstands, ESR, einer oder mehrerer der Vielzahl von Ultrakondensatorzellen basierend auf den zu spezifischen Zeitpunkten gemessenen Spannungen und einer Magnitude des Ladestroms I_ESR (Schritt 308);
Liefern eines Ladestroms I_Capacitance, der aus einem einzelnen Stromimpuls besteht, von dem DC-DC-Wandler (104, 112, 112a, 112b) an die Vielzahl von Ultrakondensatorzellen (116, C1-C5) (Schritt 306, Schritt 410);
Messen von Spannungen über eine oder mehrere der Vielzahl von Ultrakondensatorzellen (116, C1-C5) zu spezifischen Zeitpunkten in Bezug auf den Ladestrom I_Capacitance (Schritt 306, Schritt 412); und
Berechnen einer Kapazität einer oder mehrerer der Vielzahl von Ultrakondensatorzellen (116, C1, C5) basierend auf den zu spezifischen Zeitpunkten gemessenen Spannungen und einer Magnitude des Ladestroms I_Capacitance (Schritt 308).

13. Verfahren nach Anspruch 12, wobei der ESR basierend auf der folgenden Gleichung berechnet wird:

$$ESR = \frac{V_{T1} - V_{T2}}{I\_ESR\_magnitude}$$

wobei $VT_1$ eine Spannung ist, die unmittelbar vor dem Ende eines dem Ladestrom I_ESR zugeordneten Stromimpulses gemessen wird, und $VT_2$ eine Spannung ist, die unmittelbar nach dem Ende des dem Ladestrom I_ESR zugeordneten Stromimpulses gemessen wird, wobei I_ESR_*magnitude* eine Magnitude des Stromimpulses ist.

14. Verfahren nach Anspruch 12 oder 13, wobei die Kapazität basierend auf der folgenden Gleichung berechnet wird:

$$Capacitance = \frac{\int_{t5}^{t6} I\_Capacitance \, dt}{V_{t7} - V_{t5}}$$

wobei $Vt_7$ eine Spannung ist, die in einem Zeitraum nach dem einzelnen Stromimpuls gemessen wird, und $Vt_5$ eine Spannung ist, die unmittelbar vor der Abgabe des einzelnen Stromimpulses gemessen wird, wobei I_*Capacitance* der von dem DC-DC-Wandler (104, 112, 112a, 112b) gelieferte Ladestrom ist, der aus einem einzelnen Impuls besteht, der sich von Zeitpunkt *t5* bis Zeitpunkt *t6* erstreckt.

**Revendications**

1. Un module ultra-condensateur, UCM (106), comprenant :

    un convertisseur continu-continu (112, 112a, 112b) ;
    une pluralité de cellules d'ultra-condensateur (116, C1-C5) connectées pour recevoir de la puissance en provenance du, et sourcer de la puissance vers le, convertisseur continu-continu (112, 112a, 112b) ; et
    un contrôleur UCM (114) configuré pour surveiller un courant généré par le convertisseur continu-continu (112, 112a, 112b) et une tension associée à chacune de la pluralité de cellules d'ultra-condensateur (116, C1-C5), et qui contrôle le convertisseur continu-continu (112, 112a, 112b) sur la base du courant surveillé pour générer un profil de courant et utilise les tensions surveillées pour mesurer un ou plusieurs paramètres associés à chacune de la pluralité de cellules d'ultra-condensateur (C1-C5) et/ou à la pluralité de cellules d'ultra-condensateur (116), **caractérisé en ce que** les un ou plusieurs paramètres comprennent la résistance série effective, ESR, et/ou la capacité, et **en ce que** l'ESR est calculée pour chacune de la pluralité de cellules d'ultra-condensateur (C1-C5) par mesure de la tension associée à chacune de la pluralité de cellules d'ultra-condensateur (C1-C5) en des points spécifiques associés au profil de charge, dans lequel le profil de charge utilisé pour mesurer l'ESR comprend une pluralité d'impulsions de courant.

2. L'UCM (106) de la revendication 1, dans lequel l'ESR est calculée sur la base de l'équation :

$$ESR = \frac{V_{T1} - V_{T2}}{I\_ESR\_magnitude}$$

    dans laquelle $VT_1$ est la tension mesurée juste avant que finisse une impulsion de courant associée au profil de charge et $VT_2$ est une tension mesurée juste après que s'est terminée l'impulsion de courant associée au profil de charge, et dans laquelle $I\_ESR\_magnitude$ est une amplitude de l'impulsion de courant.

3. Un module ultra-condensateur, UCM (106), comprenant :

    un convertisseur continu-continu (112, 112a, 112b) ;
    une pluralité de cellules d'ultra-condensateur (116, C1-C5) connectées pour recevoir de la puissance en provenance du, et sourcer de la puissance vers le, convertisseur continu-continu (112, 112a, 112b) ; et
    un contrôleur UCM (114) configuré pour surveiller un courant généré par le convertisseur continu-continu (112, 112a, 112b) et une tension associée à chacune de la pluralité de cellules d'ultra-condensateur (116, C1-C5), et qui contrôle le convertisseur continu-continu (112, 112a, 112b) sur la base du courant surveillé pour générer un profil de courant et utilise les tensions surveillées pour mesurer un ou plusieurs paramètres associés à chacune de la pluralité de cellules d'ultra-condensateur (C1-C5) et/ou à la pluralité de cellules d'ultra-condensateur (116), **caractérisé en ce que** les un ou plusieurs paramètres comprennent la résistance série effective, ESR, et/ou la capacité, et **en ce que** la capacité est calculée pour chacune de la pluralité de cellules d'ultra-condensateur (C1-C5) par mesure de la tension associée à chacune de la pluralité de cellules d'ultra-condensateur (C1-C5) en des points spécifiques associés au profil de charge, dans lequel le profil de charge utilisé pour mesurer la capacité comprend une impulsion de courant unique ayant une durée déterminée.

4. L'UCM (106) de la revendication 3, dans lequel la capacité *CAPACITANCE* est calculée sur la base de l'équation :

$$CAPACITANCE = \frac{\int_{t5}^{t6} I\_Capacitance\,dt}{V_{t7} - V_{t5}}$$

    dans laquelle $VT_7$ est la tension mesurée à une période temporelle qui suit l'impulsion de courant unique et $VT_5$ est une tension mesurée juste après que l'impulsion de courant unique a été délivrée, et dans laquelle *I Capacitance* est le profil de courant associé à l'impulsion de courant unique.

5. L'UCM (106) de l'une des revendications précédentes, comprenant en outre un capteur de courant (210a, 210b, 212) utilisé pour mesurer le courant généré par le convertisseur continu-continu (112, 112a, 112b), le capteur de courant (210a, 210b, 212) mesurant le courant délivré à la pluralité de cellules d'ultra-condensateur (116, C1-C5) par le convertisseur continu-continu (112, 112a, 112b).

6. L'UCM (106) de la revendication 5, dans lequel le contrôleur UCM utilise le courant mesuré par le capteur de courant (210a, 210b, 212) pour contrôler le fonctionnement du convertisseur continu-continu (112, 112a, 112b) pour délivrer le profil de courant, et utilise le courant mesuré par le capteur de courant (210a, 210b, 212) pour calculer l'ESR et/ou la capacité associées à chacune de la pluralité de cellules d'ultra-condensateur (C1-C5).

7. L'UCM (106) de l'une des revendications précédentes, dans lequel le contrôleur UCM (114) commence la mesure des un ou plusieurs paramètres en réponse à une communication indiquant que des conditions d'un véhicule sont appropriées.

8. Un système électrique de véhicule (100) comprenant :

un bus de tension (118) ;
un convertisseur continu-continu de véhicule (104) couplé entre une source d'alimentation du véhicule (102) et le bus de tension (118) et configuré pour délivrer de la puissance vers/depuis le bus de tension (118) bidirectionnellement ;
une charge de véhicule (108) couplée au bus de tension (118) et configurée pour recevoir de la puissance depuis le bus de tension (118) ;
un module ultra-condensateur, UCM (106), couplé au bus de tension (118), l'UCM (106) délivrant de la puissance vers/depuis le bus de tension (118) bidirectionnellement, l'UCM (106) comprenant :

une pluralité de cellules d'ultra-condensateur (116, C1-C5) ;
un convertisseur continu-continu (112, 112a, 112b) monté en série entre le bus de tension (118) et la pluralité de cellules d'ultra-condensateur (116, C1-C5) ; et
un contrôleur UCM (114) configuré pour commencer un autotest d'UCM, le contrôleur UCM (114) faisant en sorte que le convertisseur continu-continu (112, 112a, 112b) source un profil de courant sélectionné vers la pluralité de cellules d'ultra-condensateur (116, C1-C5) et mesure un ou plusieurs paramètres associés à chacune de la pluralité de cellules d'ultra-condensateur (116, C1-C5), le contrôleur UCM (114) mesurant la résistance série effective, ESR, et/ou la capacité de la pluralité de cellules d'ultra-condensateur (116, C1-C5) sur la base des paramètres mesurés ; et

un contrôleur de véhicule (110) configuré pour communiquer avec le convertisseur continu-continu (112, 112a, 112b), avec la charge de véhicule (108), et avec l'UCM (106), le contrôleur de véhicule (110) délivrant au contrôleur UCM (114) des instructions pour commencer l'autotest d'UCM, **caractérisé en ce que** le contrôleur de véhicule reçoit en réponse l'ESR et/ou la capacité mesurées associées à chacune de la pluralité de cellules d'ultra-condensateur (C1-C5), et **en ce que** l'ESR est calculée pour chacune de la pluralité de cellules d'ultra-condensateur (C1-C5) par mesure de la tension associée à chacune de la pluralité de cellules d'ultra-condensateur (C1-C5) en des points spécifiques associés au profil de charge, dans lequel le profil de charge utilisé pour mesurer l'ESR comprend une pluralité d'impulsions de courant.

9. Un système électrique de véhicule (100) comprenant :

un bus de tension (118) ;
un convertisseur continu-continu de véhicule (104) couplé entre une source d'alimentation du véhicule (102) et le bus de tension (118) et configuré pour délivrer de la puissance vers/depuis le bus de tension (118) bidirectionnellement ;
une charge de véhicule (108) couplée au bus de tension (118) et configurée pour recevoir de la puissance depuis le bus de tension (118) ;
un module ultra-condensateur, UCM (106), couplé au bus de tension (118), l'UCM (106) délivrant de la puissance vers/depuis le bus de tension (118) bidirectionnellement, l'UCM (106) comprenant :

une pluralité de cellules d'ultra-condensateur (116, C1-C5) ;
un convertisseur continu-continu (112, 112a, 112b) monté en série entre le bus de tension (118) et la pluralité de cellules d'ultra-condensateur (116, C1-C5) ; et
un contrôleur UCM (114) configuré pour commencer un autotest d'UCM, le contrôleur UCM (114) faisant en sorte que le convertisseur continu-continu (112, 112a, 112b) source un profil de courant sélectionné vers la pluralité de cellules d'ultra-condensateur (116, C1-C5) et mesure un ou plusieurs paramètres associés à chacune de la pluralité de cellules d'ultra-condensateur (116, C1-C5), le contrôleur UCM (114) mesurant la résistance série effective, ESR, et/ou la capacité de la pluralité de cellules d'ultra-condensateur (116, C1-C5) sur la base des paramètres mesurés ; et

un contrôleur de véhicule (110) configuré pour communiquer avec le convertisseur continu-continu (112, 112a, 112b), avec la charge de véhicule (108), et avec l'UCM (106), le contrôleur de véhicule (110) délivrant au contrôleur UCM (114) des instructions pour commencer l'autotest d'UCM, **caractérisé en ce que** le contrôleur de véhicule reçoit en réponse l'ESR et/ou la capacité mesurées associées à chacune de la pluralité de cellules d'ultra-condensateur (C1-C5), et **en ce que** la capacité est calculée pour chacune de la pluralité de cellules d'ultra-condensateur (C1-C5) par mesure de la tension associée à chacune de la pluralité de cellules d'ultra-condensateur (C1-C5) en des points spécifiques associés au profil de charge, dans lequel le profil de charge utilisé pour mesurer la capacité comprend une impulsion de courant unique ayant une durée déterminée.

10. Le système électrique de véhicule (102) de l'une des revendications 8 ou 9, dans lequel le contrôleur de véhicule (110) commence un autotest d'UCM en réponse au fait qu'une ou plusieurs conditions sont vérifiées.

11. Le système électrique de véhicule (102) de l'une des revendications 8 à 10, dans lequel les une ou plusieurs conditions comprennent une confirmation reçue en provenance du convertisseur continu-continu (112, 112a, 112b) que suffisamment de puissance/de courant est disponible pour que l'UCM (106) effectue l'autotest d'UCM, ou en réponse au fait que le véhicule est au repos et/ou dans lequel le contrôleur de véhicule (110) commence un autotest d'UCM en réponse à un statut de la charge de véhicule (108).

12. Un procédé d'autotest de cellules d'ultra-condensateur (116, C1-C5) incluses en tant que parties d'un module d'ultra-condensateur, UCM (106), le procédé comprenant :

le sourçage à partir d'un convertisseur continu-continu (104, 112, 112a, 112b) d'un courant de charge *I_ESR* constitué d'une pluralité d'impulsions de courant vers la pluralité de cellules d'ultra-condensateur (116, C1-C5) (étape 306, étape 404) ;
la mesure des tensions entre une ou plusieurs de la pluralité de cellules d'ultra-condensateur à des instants spécifiques par rapport au courant de charge *I_ESR* (étape 106, étape 406) ;
le calcul d'une résistance série effective, ESR, d'une ou plusieurs de la pluralité de cellules d'ultra-condensateur sur la base des tensions mesurées à des instants spécifiques et d'un niveau du courant de charge *I_ESR* (étape 308) ;
le sourçage depuis le convertisseur continu-continu (104, 112, 112a, 112b) d'un courant de charge *I_capacitance* constitué d'une unique impulsion de courant vers la pluralité de cellules d'ultra-condensateur (116, C1-C5) (étape 306, étape 410) ;
la mesure des tensions entre une ou plusieurs de la pluralité de cellules d'ultra-condensateur (116, C1-C5) à des instants spécifiques par rapport au courant de charge *I_capacitance* (étape 306, étape 412) ; et
le calcul d'une capacité d'une ou plusieurs de la pluralité de cellules d'ultra-condensateur (116, C1-C5) sur la base des tensions mesurées à des instants spécifiques et d'un niveau du courant de charge *I_capacitance* (étape 308).

13. Le procédé de la revendication 12, dans lequel l'ESR est calculée sur la base de l'équation :

$$ESR = \frac{V_{T1} - V_{T2}}{I\_ESR\_magnitude}$$

dans laquelle $VT_1$ est la tension mesurée juste avant que finisse une impulsion de courant associée au profil de charge et $VT_2$ est une tension mesurée juste après que s'est terminée l'impulsion de courant associée au profil de charge, et dans laquelle *I_ESR_magnitude* est une amplitude de l'impulsion de courant.

14. Le procédé de la revendication 12 ou 13, dans lequel la capacité *Capacitance* est calculée sur la base de l'équation :

$$Capacitance = \frac{\int_{t5}^{t6} I\_Capacitance\, dt}{V_{t7} - V_{t5}}$$

dans laquelle $Vt_7$ est la tension mesurée à une période temporelle qui suit l'impulsion de courant unique et $Vt_5$ est une tension mesurée juste après que l'impulsion de courant unique a été délivrée, et dans laquelle *I_Capacitance* est le courant de charge sourcé depuis le convertisseur continu-continu (104, 112, 112a, 112b) constitué d'une unique impulsion qui s'étend de l'instant $t_5$ à l'instant $t_6$.

FIG. 1

**FIG. 2**

300

302

VEHICLE CONDITIONS
APPROPRIATE FOR
INITIATING UCM TEST?

NO

YES

304

POWER SOURCE
SUPPLYING POWER TO
THE UCM IS ON?

NO

YES

306 INITIATE ESR AND CAPACITANCE TEST OF
THE UCM USING CALIBRATED PRECISION
CURRENT

308 CALCULATE ESR AND CAPACITANCE BASED
ESR AND CAPACITANCE TEST

310 OUTPUT/COMMUNICATE ESR, CAPACITANCE
VALUES

# FIG. 3

306

| 400 | PRECONDITION CELL VOLTAGE TO A STARTING VOLTAGE *V_start* BY CHARGING/ DISCHARGING THE UCM STACK |
| --- | --- |
| 402 | REST FOR TIME *T_rest1* |
| 404 | APPLY CHARGING CURRENT PULSES *I_ESR* FOR TIME *T_ESR* |
| 406 | MEASURE CELL VOLTAGES AT SPECIFIC TIME POINTS ASSOCIATED WITH CURRENT PULSES *I_ESR* |
| 408 | REST FOR TIME *T_rest2* |
| 410 | APPLY CHARGING CURRENT *I_CAPACITANCE* FOR TIME *T_Capacitance* |
| 412 | MEASURE CELL VOLTAGES AT SPECIFIC TIME INTERVALS ASSOCIATED WITH CHARGING CURRENT *I_CAPACITANCE* |

## FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018166892 A1